# EUROPEAN PATENT SPECIFICATION

(11) **EP 0 533 402 B1**
(45) Date of publication and mention of the grant of the patent: **02.04.1997**
(21) Application number: 92308248.1
(22) Date of filing: 10.09.1992
(51) Int. Cl.: H03K 5/13, H03K 5/04, H03K 3/017, H03H 11/26

(54) **Controlled time delay line**
Leitung mit geregelter Zeitverzögerung
Ligne à retard de temps contrôlé

(30) Priority: 16.09.1991 US 760659
(43) Date of publication of application: 24.03.1993
(73) Proprietor: Nippon Motorola Ltd., Tokyo 106 (JP)
(72) Inventor: Kase, Kiyoshi, Chiba-shi, Chiba (JP)
(74) Representative: Hudson, Peter David

(56) References cited:
- PATENT ABSTRACTS OF JAPAN vol. 13, no. 110 (E-728)(3458) 16 March 1989;& JP-A-63281514
- PATENT ABSTRACTS OF JAPAN vol. 014, no. 489 (E-0994)24 October 1990;& JP-A-2202112
- PATENT ABSTRACTS OF JAPAN vol. 11, no. 341 (E-554)(2788) 7 November 1987;& JP-A-62122318
- PATENT ABSTRACTS OF JAPAN vol. 12, no. 106 (E-596)(2953) 6 April 1988;& JP-A-62234413

## Description

This invention relates, in general, to CMOS delay lines.

CMOS delay lines are often used for high frequency clock synchronization for video signals and parallel micro controller units (MCU).

A CMOS delay line is generally composed of multiple CMOS inverters or a cascaded CMOS inverter chain such as 32-stage series inverters Each inverter, or cascaded inverter, has a slightly different rise and fall time as well as slightly different threshold voltage. Such variations are caused by small geometric mismatches of the transistors and stray capacitance around the transistors.

As a digital signal is propagated through the multiple or cascaded inverters, the small variations in rise and fall times accumulate. The output duty cycle time of the signal (duty cycle time is the portion of the input signal registering a high, or above the threshold voltage) will be changed from the original input signal to be delayed.

A worst case scenario involves a high frequency input signal having a low duty cycle time. In this case, the output pulse can become very narrow and generate a clock re-synchronization malfunction in the circuits the delay line is outputting to.

To avoid the problems of signal mismatching and narrow output pulses, the duty cycle time must be controlled to maintain a duty cycle approximately equal to the input signal duty cycle.

Furthermore, it is desirable to maintain a certain duty cycle range generated by each individual delay inverter. This allows control of the total duty cycle generated by the entire string or series of delay inverters.

From Japanese publication JP63281514, Eguchi Takeo, Sony Corporation, there is known an attempt to correct signal mismatching and narrow output pulses. Although this publication shows a way to correct some of the mismatching and narrow output pulses, a major part of the problem remains since this publication discloses only the use of a single feedback signal.

### Summary of the Invention

In accordance with the present invention there is provided a delay line as claimed in claim 1.

The above and other objects, features, and advantages of the present invention will be better understood from the following detailed description taken in conjunction with the accompanying drawings.

### Brief Description of the Drawing

Fig. 1 is a schematic of a delay unit for a CMOS delay line according to the present invention.

Fig. 2 is a schematic of a portion of the delay unit of Fig. 1 showing the components thereof according to the present invention.

Fig. 3 is a plot of an input digital signal at the input, after passing through the first half of the delay unit of Fig. 1, and at the output of the delay unit of Fig. 1 according to the present invention.

Fig. 4 is a schematic of the CMOS delay line having duty cycle control according to the present invention.

Fig. 5 is a schematic of a multiple MCU system utilizing the CMOS delay line of the present invention.

### Detailed Description of the Invention

The basic delay unit for a CMOS delay line according to the present invention is shown in Fig. I and comprises a CMOS inverter with cascaded P-channel current sources and N-channel current sources. The delay unit 10 comprises two inverters 12 and 14. The operation of inverters 12 and 14 will be explained below. A voltage represented by NBP supplies inverter 12, and another voltage represented by NBN supplies inverter 14. The significance of these two voltages is also described later.

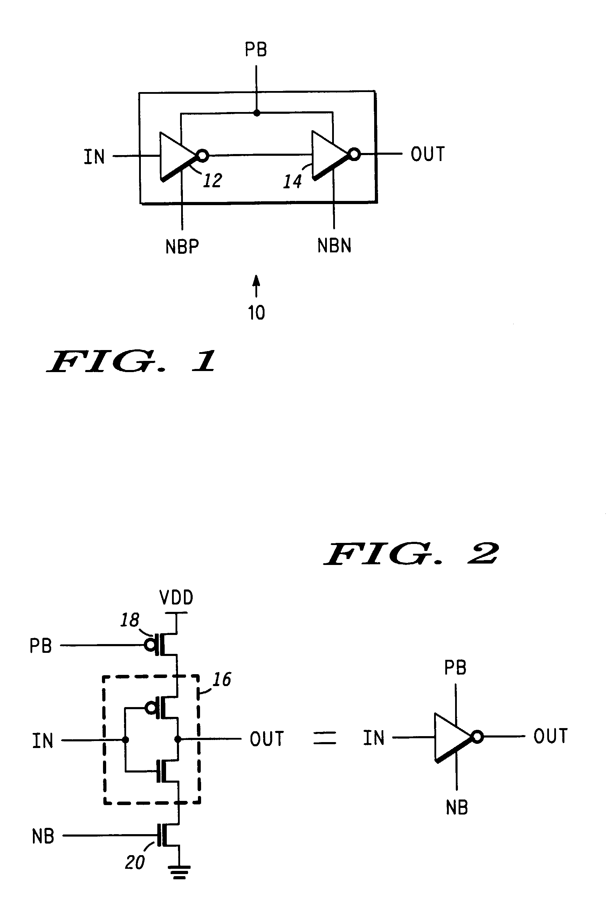

Fig. 2 shows the construction of each of the inverters 12 and 14. Specifically, inverter portion 16 is controlled by signals from two transistors; P-channel transistor 18 and N-channel transistor 20. P-channel transistor 18 receives a constant current thus generating a bias voltage for inverters 12 and 14. The bias voltage at P-channel transistor 18 controls the total cycle time (high and low level combined) of each delay unit. A voltage input at N-channel transistor 20 controls the high level or duty cycle time of each delay unit.

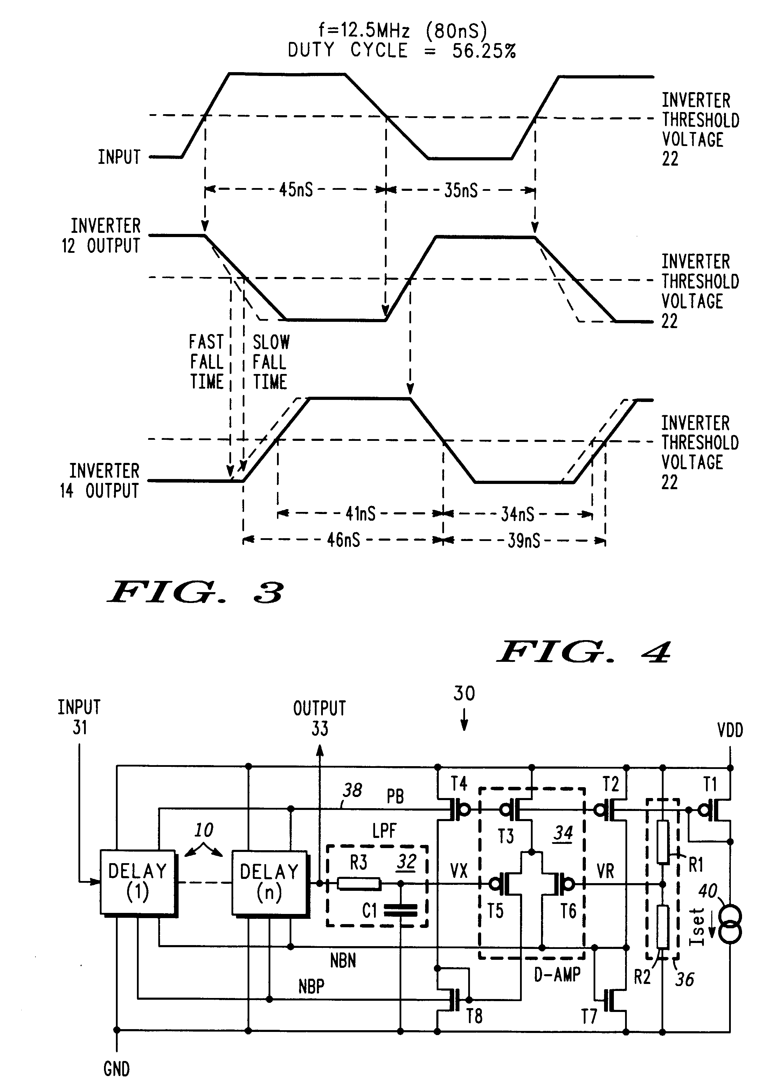

Fig. 3 shows an input digital signal at the input, and the signal as it passes through inverter 12 and inverter 14. When input, the signal has a duty cycle of 56.25%. In other words, with reference to the threshold voltage 22, the signal registers a high level (above threshold voltage 22) for 45 nS (nano seconds), and the signal registers a low level (below threshold voltage 22) for 35 nS. The duty cycle is the percent of time greater than threshold voltage 22 as compared with the total cycle time. Therefore, with this signal's frequency of 12.5MHz or 80 nS, the duty cycle is found by 45/80 equals 0.5625 or 56.25% duty cycle.

As seen from the outputs of inverters 12 and 14 in Fig. 3, the rate of fall time will effect the total high level and total low level time at the output. The total cycle time remains constant. As the fall time increases (represented as slow fall time), the high level time, or duty cycle, remains constant. As the fall time decreases (fast fall time), the high level time increases causing a decrease in the low level time.

The duty cycle time is similarly affected by the rise time. In Fig. 3, the rise time in inverter 14 output is shown as shifted by the fast or slow fall times. Although shifted, the rate, or slope, of rise remains constant. It should be noted that although the rise time is shown constant in Fig. 3, the slope or rate of change of the rise time generally changes as the fall time slope changes. The two (rise and fall times) act in conjunction with each other.

In the example of Fig. 3, the fast fall time causes a high level of 46 nS (increase of 1 nS) for a duty cycle of 57.5%. The low level has decreased to 34 nS. The slow fall time causes a high level of 41 nS (decrease of 4 nS) with a duty cycle of 51.25% and an increased low level of 39 nS.

Given the degree of variation in duty cycle time in just one delay unit such as delay unit 10, it is easy to understand why there must be a control on the fall, and/or the rise, time of the digital signal in the delay line. For instance, assume an implementation of 32 delay units such as may be used for high frequency clock synchronization application like video signaling and parallel micro controller unit (MCU) clock synchronization. These delay units are coupled together in series. As a digital signal propagates through the string of delay units, in the example of Fig. 3, the final additional duty cycle time accumulated through the delay line for the fast fall time would be 32 nS (an increase of 1 nS per delay unit) resulting in a high level signal of 77 nS or almost 100% of the signal. On the other hand, the slow fall time results in (-4 nS)×32 = -128 nS. In other words, the signal would not be present at the output.

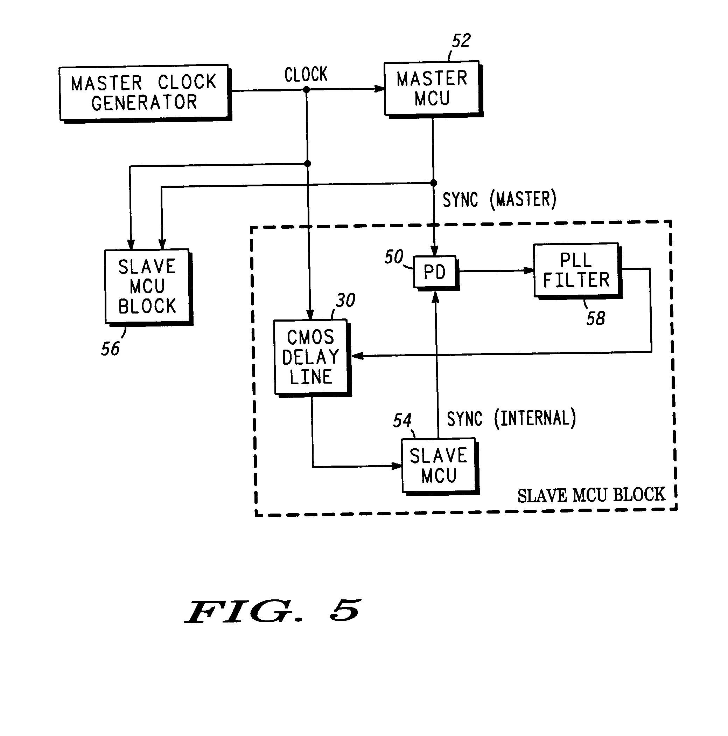

Fig. 4 shows the entire circuitry of a CMOS delay line 30 according to the present invention. In general, CMOS delay line 30 comprises n delay units 10 (in the previous example, n=32 delay units), low pass filter (LPF) 32, differential amplifier 34, and voltage divider 36.

As mentioned previously in relation to Figures 1 and 2, a bias voltage is supplied to the P-channel transistor (16) of each delay unit 10. This bias voltage is maintained at a constant voltage to maintain the total cycle time. The constant voltage is supplied through line 3b from transistor T1. The voltage is generated within T1 by a constant current "Iset". Iset is set at a constant by current source 40. Current mirrors T2, T3, and T4 mirror the current Iset for transistors T7, T5 and T6, and T8 respectively..

The line for voltage NBN is coupled from delay units 10 to transistor T7. The voltage generated by current through T7 controls inverter 14 of each delay unit 10. The line for voltage NBP is coupled from delay units 10 to transistor T8. The voltage generated by current through T8 controls inverter 14 of each delay unit 10.

LPF 32 is coupled to the output from the series delay units 10 to receive the delayed outputs, and is further coupled to differential amplifier 34. LPF 32 may be a simple low pass filter comprised of a resistance R3 and a capacitance to ground C1.

Differential amplifier 34 is comprised of current mirror transistor T3, and transistors T5 and T6 coupled in parallel to current mirror transistor T3. T5 is coupled to the output of LPF 32 as well as coupled to transistor T8. Transistor T6 is coupled to voltage divider 36. Voltage divider 36 supplies a constant voltage to transistor T6 equal to V_{DD}/2, or generally 5V/2= 2.5V. Transistor T6 is also coupled to transistor T7.

The circuit input 31 is coupled to the first delay unit 10, and the circuit output 33 is coupled to the last delay unit 10.

The operation of CMOS delay line 30 is as follows. Iset is generated by current source 40 and is a constant. Iset generates a voltage in transistor T1 as it passes through. The current Iset is mirrored by transistors T2, T3, and T4. Since Iset is always a constant, the voltage supplied from transistor T1 is also a constant. This voltage is supplied to each P-channel transistor 18 of each delay unit 10. As explained above, this supplies a constant current source to inverters 12 and 14 of the delay unit 10 generating a constant bias voltage.

The current Iset is continuously passing through transistors T7 and T8 due to current mirror transistors T2 and T4 respectively. This generates the two voltages NBN and NBP. Without the addition of current from another source (i.e. transistors T5 and T6), voltages NBN and NBP would remain constant.

Each digital signal passing through the delay units 10 is output to LPF 32. LPF 32 will output a voltage signal proportional to the length of the duty cycle. If the duty cycle time at the output is long, LPF 32 will output a high voltage signal to transistor T5 of differential amplifier 34. Transistor T5 is continuously on. Therefore, a high voltage signal will reduce the current through T5. The degree to which the current through T5 is reduced is proportional to the signal from LPF 32. As the current through T5 is reduced, more current will be supplied through T6. The increased current through T6 will then generate a proportional and additional voltage at T7 which is transmitted to the NBN, and therefore to N-channel transistor 16 of inverter 14 (second half of delay unit 10) of delay units 10. At the same time, the decrease of current through T5 will drain current from T8 causing a decrease in the voltage NBP. The net result of an increased NBN voltage and decreased NBP voltage is a fast rise and slow fall time in inverter 12, and slow rise and fast fall time in inverter 14. This results in a reduced duty cycle in each delay unit 10.

As the voltage from LPF 32 decreases, the current through T5 will increase and the current through T6 will decrease. Therefore the current through T8 will increase generating a higher voltage signal in NBN, while the current through T7 will be proportionally drained dropping the voltage of NBN. The result of a decreased NBN voltage and increased NBP voltage is a slow rise and fast fall time in inverter 12, and fast rise and slow fall time in inverter 14. The net result is an increase duty cycle in each delay unit 10.

From the above description, one skilled in the art will recognize that voltage divider 36 sets the duty cycle (%) of the delay units 10.

Fig. 5 shows one use of CMOS delay line 30. In this particular embodiment, the CMOS delay line is a clock synchronizer for multiple MCU's. The synchronization is required to minimize processing skew among the different MCU's (slave and master).

In Fig. 5, a phase detector (PD) 50 determines the skew time of the master MCU 52 in relation to slave MCU 54 and other slave MCU blocks 56. The output of PD 50 controls, through a phase lock loop filter 58, the Iset of CMOS delay line 30.

Thus there has been provided, in accordance with the present invention, a CMOS delay line having duty control that fully satisfies the objects, aims, and advantages set forth above. While the invention has been described in conjunction with specific embodiments thereof, it is evident that many alternatives, modifications, and variations will be apparent to those skilled in the art in light of the foregoing description. Accordingly, it is intended to embrace all such alternatives, modifications, and variations as fall within the scope of the appended claims.

## Claims

1. A delay line for supplying a controlled time delay to an input signal, the delay line comprising:
at least one delay unit (10) coupled to an input (31);
said at least one delay unit having at least one control input;
the input signal propagating through said at least one delay unit and accumulating a change in a duty cycle;
said at least one delay unit having an output (33) wherein said input signal is output having a total duty cycle;
means for generating a correction voltage signal (32, 34), the value of said correction voltage signal being proportional to the value of said total duty cycle;
said means for generating being coupled to said output of said at least one delay unit to receive said total duty cycle;
said means for generating being coupled to said control input of said at least one delay unit, said at least one delay unit receiving said correction voltage signal from said means for generating; and
said at least one delay unit adjusting said duty cycle according to said correction voltage signal,
characterized in that said at least one delay unit comprises two CMOS-inverters, each inverter comprising N-channel transistor for controlling the high level or duty cycle time of the inverter;
said means for generating comprises:
means for outputting a duty cycle voltage (32), the value of said duty cycle voltage being proportional to the value of said total duty cycle;
said means for outputting being coupled to said output of said at least one delay unit to receive said total duty cycle;
differential amplifier means (34) coupled to said means for outputting to receive said duty cycle voltage;
said differential amplifier means having a first and second output;
said differential amplifier means increasing current through said first output and decreasing current through said second output when said duty cycle voltage is small, or alternatively decreasing current through said first output and increasing current through said second output when said duty cycle is large;
first and second voltage generator means (T7, T8) generating a voltage when a current is applied;
said first and second voltage generator means being coupled to said first and second outputs of said differential amplifier means respectively;
said first and second voltage generator means being coupled to said at least one delay unit;
said first voltage generator means (T8) outputting said correction voltage signal causing a decrease in said duty cycle;
said second voltage generator means (T7) outputting said correction voltage signal causing an increase in said duty cycle; and
the value of said correction signal from said first and second voltage generator means being controlled by current from said first and second outputs of said differential amplifier means respectively.

2. A delay line for supplying a controlled time delay to an input signal according to claim 1 wherein the delay line further comprises:
bias means (T1);
each of said at least one delay unit having a bias input;
said bias means being coupled to said bias input of each of said at least one delay unit;
said bias means supplying a bias voltage to said bias input of each of said at least one delay unit;
said bias voltage being generated within said bias means by a constant current;
a current source (40) supplying said constant current to said bias means; and
said current source being coupled to said bias means.

3. A delay line for supplying a controlled time delay to an input signal according to claim 1 or 2 wherein said differential amplifier means comprises:
first current mirror means (T3);
a first transistor (T5) coupled to said first output, said first transistor further coupled to said first current mirror means;
a second transistor (T6) coupled to said second output, said second transistor further coupled to said first current mirror means;
said first current mirror means supplying said constant current from said bias means to said first and second transistors;
said first transistor being coupled to said means for outputting to receive said duty cycle voltage;
a flow of current through said first transistor reducing when said duty cycle voltage increases causing an increase in the flow of current through said second transistor;
a flow of current through said first transistor increasing when said duty cycle voltage decreases causing a decrease in flow of current through said second transistor; and
said second transistor being coupled to a constant voltage source.

4. A delay line for supplying a controlled time delay to an input signal according to claim 3 wherein the delay line further comprises:
second current mirror means (T4) coupled to said first voltage generator means and to said bias means;
said second current mirror means supplying said constant current from said bias means to said first voltage generator means;
third current mirror means (T2) coupled to said second voltage generator means and to said bias means; and
said third current mirror means supplying said constant current from said bias means to said second voltage generator means.

5. A delay line for supplying a controlled time delay to an input signal according to claim 1 wherein said differential amplifier means comprises:
current means for supplying a constant current (40);
a first transistor (T5) coupled to said first output, said first transistor further being coupled to said current means;
a second transistor (T6) coupled to said second output, said second transistor further being coupled to said current means;
said first transistor being coupled to said means for outputting to receive said duty cycle voltage;
a flow of current through said first transistor reducing when said duty cycle voltage increases causing an increase in the flow of current through said second transistor;
a flow of current through said first transistor increasing when said duty cycle voltage decreases causing a decrease in flow of current through said second transistor; and
said second transistor coupled to a constant voltage source (36).

## Patentansprüche

1. Verzögerungsleitung zum Aufbringen einer kontrollierten Zeitverzögerung auf ein Eingangssignal, wobei die Verzögerungsleitung aufweist:
mindestens eine Verzögerungseinheit (10), die mit einem Eingang (31) gekoppelt ist;
wobei die mindestens eine Verzögerungseinheit mindestens einen Steuereingang besitzt;
wobei sich das Eingangssignal durch die mindestens eine Verzögerungseinheit ausbreitet und eine Änderung in einem Taktzyklus akkumuliert;
wobei die mindestens eine Verzögerungseinheit einen Ausgang (33) besitzt, wobei das Eingangssignal ausgegeben wird, das einen Gesamttaktzyklus besitzt;
eine Erzeugungseinrichtung eines Korrektur-Spannungssignals (32, 34), wobei der Wert des Korrektur-Spannungssignals proportional zu dem Wert des Gesamttaktzyklus ist;
wobei die Erzeugungseinrichtung mit dem Ausgang der mindestens einen Verzögerungseinheit gekoppelt ist, um den Gesamttaktzyklus aufzunehmen;
wobei die Erzeugungseinrichtung mit dem Steuereingang der mindestens einen Verzögerungseinheit gekoppelt ist, wobei die mindestens eine Verzögerungseinheit das Korrektur-Spannungssignal von der Erzeugungseinrichtung aufnimmt; und
wobei die mindestens eine Verzögerungseinheit den Taktzyklus gemäß dem Korrektur-Spannungssignal einstellt,
gekennzeichnet dadurch, daß die mindestens eine Verzögerungseinheit zwei CMOS-Inverter aufweist, wobei jeder Inverter einen N-Kanal-Transistor zum Steuern des hohen Pegels oder der Taktzykluszeit des Inverters aufweist;
wobei die Erzeugungseinrichtung aufweist:
eine Einrichtung zum Ausgeben einer Taktzyklus-Spannung (32), wobei der Wert der Taktzyklus-Spannung proportional zu dem Wert des gesamten Taktzyklus ist;
wobei die Einrichtung zum Ausgeben mit dem Ausgang der mindestens einen Verzögerungseinheit gekoppelt ist, um den gesamten Taktzyklus aufzunehmen;
eine Differentialverstärkereinrichtung (34), die mit der Einrichtung zum Ausgeben gekoppelt ist, um die Taktzyklusspannung aufzunehmen;
wobei die Differentialverstärkereinrichtung einen ersten und einen zweiten Ausgang besitzt;
wobei die Differentialverstärkereinrichtung einen Strom durch den ersten Ausgang erhöht und einen Strom durch den zweiten Ausgang erniedrigt, wenn die Taktzyklusspannung klein ist, oder alternativ den Strom durch den ersten Ausgang erniedrigt und den Strom durch den zweiten Ausgang erhöht, wenn der Taktzyklus groß ist;
wobei die erste und die zweite Spannungserzeugungseinrichtung (T7, T8) eine Spannung erzeugt, wenn ein Strom angelegt wird;
wobei die erste und die zweite Spannungserzeugungseinrichtung mit dem ersten und dem zweiten Ausgang der Differentialverstärkereinrichtung jeweils gekoppelt ist;
wobei die erste und die zweite Spannungserzeugungseinrichtung mit der mindestens einen Verzögerungseinheit gekoppelt ist;
wobei die erste Spannungserzeugungseinrichtung (T8) das Korrekturspannungssignal ausgibt, was eine Erniedrigung in dem Taktzyklus bewirkt;
wobei die zweite Spannungserzeugungseinrichtung (T7) das Korrekturspannungssignal ausgibt, was eine Erhöhung in dem Taktzyklus bewirkt; und
wobei der Wert des Korrektursignals von der ersten und der zweiten Spannungserzeugungseinrichtung durch einen Strom von dem ersten und dem zweiten Ausgang der Differentialverstärkereinrichtung jeweils kontrolliert wird.

2. Verzögerungsleitung zum Zuführen einer gesteuerten Zeitverzögerung zu einem Eingangssignal gemäß Anspruch 1, wobei die Verzögerungsleitung weiterhin aufweist:
eine Bias-Einrichtung (T1);
wobei jede der mindestens einen Verzögerungseinheit einen Bias-Eingang besitzt;
wobei die Bias-Einrichtung mit dem Bias-Eingang jeder der mindestens einen Verzögerungseinheit gekoppelt ist;
wobei die Bias-Einrichtung eine Bias-Spannung zu dem Bias-Eingang jeder der mindestens einen Verzögerungseinheit zuführt;
wobei die Bias-Spannung innerhalb der Bias-Einrichtung durch einen konstanten Strom erzeugt wird;
wobei eine Stromquelle (40) den konstanten Strom zu der Bias-Einrichtung zuführt; und
wobei die Stromquelle mit der Bias-Einrichtung gekoppelt ist.

3. Verzögerungsleitung zum Hinzufügen einer kontrollierten Zeitverzögerung zu einem Eingangssignal gemäß Anspruch 1 oder 2, wobei die Differentialverstärkereinrichtung aufweist:
eine erste Stomspiegeleinrichtung (T3);
einen ersten Transistor (T5), der mit dem ersten Ausgang gekoppelt ist, wobei der erste Transistor weiterhin mit der ersten Stromspiegeleinrichtung gekoppelt ist;
einen zweiten Transistor (T6), der mit dem zweiten Ausgang gekoppelt ist, wobei der zweite Transistor weiterhin mit der ersten Stromspiegeleinrichtung gekoppelt ist;
wobei die erste Stromspiegeleinrichtung den konstanten Strom von der Bias-Einrichtung zu dem ersten und dem zweiten Transistor zuführt;
wobei der erste Transistor mit der Einrichtung zum Ausgeben gekoppelt ist, um die Taktzyklusspannung aufzunehmen;
wobei sich ein Stromfluß durch den ersten Transistor reduziert, wenn sich die Taktzyklusspannung erhöht, was eine Erhöhung in dem Stromfluß durch den zweiten Transistor bewirkt;
wobei sich ein Stromfluß durch den ersten Transistor erhöht, wenn sich die Taktzyklusspannung erniedrigt, was eine Erniedrigung in dem Stromfluß durch den zweiten Transistor bewirkt; und
wobei der zweite Transistor mit einer Konstant-Spannungsquelle gekoppelt ist.

4. Verzögerungsleitung zum Hinzufügen einer kontrollierten Zeitverzögerung zu einem Eingangssignal gemäß Anspruch 3, wobei die Verzögerungsleitung weiterhin aufweist:
eine zweite Stromspiegeleinrichtung (T4), die mit der ersten Spannungserzeugungseinrichtung und der Bias-Einrichtung gekoppelt ist;
wobei die zweite Stromspiegeleinrichtung den konstanten Strom von der Bias-Einrichtung zu der ersten Spannungserzeugungseinrichtung zuführt;
wobei die Stromspiegeleinrichtung (T2) mit der zweiten Spannungserzeugungseinrichtung und mit der Bias-Einrichtung gekoppelt ist; und
wobei die dritte Stromspiegeleinrichtung den konstanten Strom von der Bias-Einrichtung zu der zweiten Spannungserzeugungseinrichtung zuführt.

5. Verzögerungsleitung zum Hinzufügen einer kontrollierten Zeitverzögerung zu einem Eingangssignal gemäß Anspruch 1, wobei die Differentialverstärkereinrichtung aufweist:
eine Stromeinrichtung zum Zuführen eines konstanten Stroms (40);
einen ersten Transistor (T5), der mit dem ersten Ausgang gekoppelt ist, wobei der erste Transistor weiterhin mit der Stromeinrichtung gekoppelt ist;
einen zweiten Transistor (T6), der mit dem zweiten Ausgang gekoppelt ist, wobei der zweite Transistor weiterhin mit der Stromeinrichtung gekoppelt ist;
wobei der erste Transistor mit der Einrichtung zum Ausgeben gekoppelt ist, um die Taktzyklusspannung aufzunehmen;
wobei sich eine erster Stromfluß durch den ersten Transistor reduziert, wenn sich die Taktzyklusspannung erhöht, was eine Erhöhung in dem Stromfluß durch den zweiten Transistor bewirkt;
wobei sich ein Sromfluß durch den ersten Transistor erhöht, wenn sich die Taktzyklusspannung erniedrigt, was eine Ernierdrigung in dem Stromfluß durch den zweiten Transistor bewirkt; und
wobei der zweite Transistor mit einer Konstant-Spannungsquelle (36) gekoppelt ist.

## Revendications

1. Une ligne à retard pour appliquer un retard commandé à un signal d'entrée, la ligne à retard comprenant :
au moins une unité de retard (10) connectée à une entrée (31);
l'unité, ou les unités, de retard ayant au moins une entrée de commande;
le signal d'entrée se propageant à travers l'unité, ou les unités, de retard et accumulant un changement d'un rapport cyclique;
l'unité, ou les unités, de retard ayant une sortie (33) par laquelle le signal d'entrée est émis avec un rapport cyclique global;
des moyens pour générer un signal de tension de correction (32, 34), la valeur de ce signal de tension de correction étant proportionnelle à la valeur du rapport cyclique global;
les moyens de génération étant connectés à la sortie de l'unité, ou des unités, de retard pour recevoir le rapport cyclique global;
les moyens de génération étant connectés à l'entrée de commande de l'unité, ou des unités de retard, l'unité ou les unités de retard recevant le signal de tension de correction à partir des moyens de génération; et
l'unité, ou les unités, de retard ajustant le rapport cyclique conformément au signal de tension de correction,
caractérisée en ce que l'unité de retard, ou chacune d'elles, comprend deux inverseurs CMOS, chaque inverseur comprenant un transistor à canal N pour commander la durée de niveau haut ou durée active de l'inverseur;
les moyens de génération comprenant :
des moyens pour fournir en sortie une tension de rapport cyclique (32), la valeur de cette tension de rapport cyclique étant proportionnelle à la valeur du rapport cyclique global;
les moyens pour fournir une tension de rapport cyclique étant connectés à la sortie de l'unité ou des unités de retard, de façon à recevoir le rapport cyclique global;
des moyens amplificateurs différentiels (34) connectés aux moyens destinés à fournir la tension de rapport cyclique, pour recevoir cette tension de rapport cyclique;
les moyens amplificateurs différentiels ayant des première et seconde sorties;
les moyens amplificateurs différentiels augmentant le courant qui circule par la première sortie et diminuant le courant qui circule par la seconde sortie lorsque la tension de rapport cyclique est faible, ou au contraire diminuant le courant qui circule par la première sortie et augmentant le courant qui circule par la seconde sortie lorsque le rapport cyclique est élevé;
des premiers et seconds moyens générateurs de tension (T7, T8), générant une tension lorsqu'un courant est appliqué;
les premiers et seconds moyens générateurs de tension étant respectivement connectés aux première et seconde sorties des moyens amplificateurs différentiels;
les premiers et seconds moyens générateurs de tension étant connectés à l'unité ou aux unités de retard;
les premiers moyens générateurs de tension (T8) fournissant en sortie le signal de tension de correction qui occasionne une diminution du rapport cyclique;
les seconds moyens générateurs de tension (T7) fournissant en sortie le signal de tension de correction qui occasionne une augmentation du rapport cyclique; et
la valeur du signal de correction provenant des premiers et seconds moyens générateurs de tension étant commandée par un courant qui provient respectivement des première et seconde sorties des moyens amplificateurs différentiels.

2. Une ligne à retard pour appliquer un retard commandé à un signal d'entrée selon la revendication 1, dans laquelle la ligne à retard comprend en outre :
des moyens de polarisation (T1);
l'unité de retard, ou chacune d'elles, ayant une entrée de polarisation;
les moyens de polarisation étant connectés à l'entrée de polarisation de l'unité de retard, ou de chacune d'elles;
les moyens de polarisation appliquant une tension de polarisation à l'entrée de polarisation de l'unité de retard, ou de chacune d'elles;
la tension de polarisation étant produite dans les moyens de polarisation par un courant constant;
une source de courant (40) fournissant le courant constant aux moyens de polarisation; et
la source de courant étant connectée aux moyens de polarisation.

3. Une ligne à retard pour appliquer un retard commandé à un signal d'entrée selon la revendication 1 ou 2, dans laquelle les moyens amplificateurs différentiels comprennent :
un premier circuit miroir de courant (T3);
un premier transistor (T5) connecté à la première sortie, ce premier transistor étant en outre connecté au premier circuit miroir de courant;
un second transistor (T6) connecté à la seconde sortie, ce second transistor étant en outre connecté au premier circuit miroir de courant;
le premier circuit miroir de courant fournissant aux premier et second transistors le courant constant qui provient des moyens de polarisation;
le premier transistor étant connecté aux moyens destinés à fournir une tension de rapport cyclique, de façon à recevoir cette tension de rapport cyclique;
un courant qui circule à travers le premier transistor diminuant lorsque la tension de rapport cyclique augmente, ce qui occasionne une augmentation du courant qui circule à travers le second transistor;
le courant qui circule à travers le premier transistor augmentant lorsque la tension de rapport cyclique diminue, ce qui occasionne une diminution du courant qui circule à travers le second transistor; et
le second transistor étant connecté à une source de tension constante.

4. Une ligne à retard pour appliquer un retard commandé à un signal d'entrée selon la revendication 3, dans laquelle la ligne à retard comprend en outre :
un second circuit miroir de courant (T4), connecté aux premiers moyens générateurs de tension et aux moyens de polarisation;
ce second circuit miroir de courant fournissant aux premiers moyens générateurs de tension le courant constant qui provient des moyens de polarisation;
un troisième circuit miroir de courant (T2), connecté aux seconds moyens générateurs de tension et aux moyens de polarisation; et
ce troisième circuit miroir de courant fournissant aux seconds moyens générateurs de tension le courant constant qui provient des moyens de polarisation.

5. Une ligne à retard pour appliquer un retard commandé à un signal d'entrée selon la revendication 3, dans laquelle les moyens amplificateurs différentiels comprennent :
une source de courant pour fournir un courant constant (40);
un premier transistor (T5), connecté à la première sortie, ce premier transistor étant en outre connecté à la source de courant;
un second transistor (T6) connecté à la seconde sortie, ce second transistor étant en outre connecté à la source de courant;
le premier transistor étant connecté aux moyens destinés à fournir une tension de rapport cyclique, de façon à recevoir cette tension de rapport cyclique;
un courant qui circule à travers le premier transistor diminuant lorsque la tension de rapport cyclique augmente, ce qui occasionne une augmentation du courant qui circule à travers le second transistor;
un courant qui circule à travers le premier transistor augmentant lorsque la tension de rapport cyclique diminue, ce qui occasionne une diminution du courant qui circule à travers le second transistor; et
le second transistor étant connecté à une source de tension constante (36).
